# EUROPEAN PATENT APPLICATION

(11) **EP 4 518 612 A1**
(43) Date of publication of application: **05.03.2025**
(21) Application number: 24315392.1
(22) Date of filing: 27.08.2024
(51) Int. Cl.: H10D 30/47, H10D 30/01, H10D 64/01, H10D 64/27, H10D 64/23, H10D 62/854, H10D 62/85

(54) **RECESSED GATE HEMT PROCESSING WITH REVERSED ETCHING**

(30) Priority: 30.08.2023 US 202318458877
(71) Applicant: STMicroelectronics International N.V., 1228 Plan-les-Ouates, Geneva (CH)
(72) Inventor: Yvon, Arnaud, 37540 SAINT-CYR SUR LOIRE (FR)
(74) Representative: Cabinet Beaumont

(57) **Abstract**

A process forms a high electron mobility transistor (HEMT) device with a recessed gate (128) without damaging sensitive areas of the HEMT device. The process utilizes a first epitaxial growth process to grow a first set of layers of the HEMT. The epitaxial growth process is then stopped and a passivation layer is formed on the first set of layers. The passivation layer is then patterned to provide a passivation structure at a desired location of the recessed gate electrode. The channel layer (118) and one or more barrier layers (120) are then formed in a second epitaxial growth process in the presence of the passivation structure. The result is that the channel layer and the barrier layer growth around the passivation structure. The passivation structure is then removed, effectively leaving a recess in the channel layer. The gate electrode (128) is then formed in the recess.

## Description

### BACKGROUND

### Technical Field

The present disclosure relates to a field-effect high electron mobility transistor (HEMT) device and to a manufacturing process thereof.

### Description of the Related Art

HEMT devices are known in which a conductive channel is based on the formation of layers of two-dimensional electron gas (2DEG) with high mobility at a heterojunction, *i.e.,* at the interface between semiconductor materials with different bandgaps. For instance, HEMT devices are known based on the heterojunction between an aluminum and gallium nitride (AlGaN) layer and a gallium nitride (GaN) layer.

HEMT devices based on AlGaN/GaN heterojunctions or heterostructures provide a wide range of advantages that make them particularly suitable for and widely used for different applications. For instance, the high breakdown threshold of HEMT devices is exploited for high-performance power switches; the high electron mobility in the conductive channel allows to obtain high-frequency amplifiers; moreover, the high electron concentration in the 2DEG allows to obtain a low ON-state resistance (R_{ON}). Furthermore, HEMT devices for radiofrequency (RF) applications typically provide better RF performance than similar silicon LDMOS devices.

Some HEMT devices may include a recessed gate. However, processes for forming the recessed gate can result in damage to sensitive layers. This can lead to poorly functioning devices or even non-functioning devices.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventor's approach to the particular problem, which, in and of itself, may also be inventive.

### BRIEF SUMMARY

Embodiments of the present disclosure provide an HEMT device with a recessed gate without damaging sensitive areas of the HEMT device. Embodiments of the present disclosure implement a first epitaxial growth process to grow a first set of layers of the HEMT. The epitaxial growth process is then stopped and a passivation layer is formed on the first set of layers. The passivation layer is then patterned to provide a passivation structure at a desired location of the recessed gate electrode. The channel layer and one or more barrier layers are then formed in a second epitaxial growth process in the presence of the passivation structure. The result is that the channel layer and the barrier layer growth around the passivation structure. The passivation structure is then removed, effectively leaving a recess in the channel layer. The gate electrode is then formed in the recess. The result of this process is that the recessed gate electrode is formed without damaging the channel layer in the back barrier layer.

In one embodiment, a method includes depositing, with a first epitaxial growth process, a back barrier layer of an HEMT and depositing, on the back barrier layer, a passivation layer. The method includes forming, on the back barrier layer, a passivation remnant by patterning the passivation layer and depositing, on the back barrier layer, a channel layer and a barrier layer of the HEMT by performing a second epitaxial growth process in the presence of the passivation remnant. The method includes forming a recess in the channel layer by removing the passivation remnant and forming a gate electrode of the HEMT in the recess.

In one embodiment, a method includes depositing, with a first epitaxial growth process, a back barrier layer of a high electron mobility transistor (HEMT) and depositing, with the first epitaxial growth process, a first portion of a channel layer of the HEMT on the back barrier layer. The method includes depositing, on the first portion of the channel layer, a passivation layer and forming, on the first portion of the channel layer, a passivation remnant by patterning the passivation layer. The method includes depositing, on the first portion of the channel layer, a second portion of the channel layer and a barrier layer of the HEMT by performing a second epitaxial growth process in the presence of the passivation remnant, removing the passivation remnant, and forming a gate electrode of the HEMT in the recess.

In one embodiment, a method includes forming, in a first epitaxial growth process, a layer of gallium nitride and forming a dielectric structure on the layer of gallium nitride. The method includes forming, in a second epitaxial growth process after forming the dielectric structure, a channel layer of a HEMT on the layer of gallium nitride in the presence of the dielectric structure, wherein sidewalls of the channel layer abut the dielectric structure. The method includes removing the dielectric structure after forming the channel layer and forming a gate electrode of the HEMT in place of the dielectric structure.

An embodiment provides a method, comprising:
depositing, with a first epitaxial growth process, a back barrier layer of a high electron mobility transistor (HEMT);
depositing a passivation layer;
forming a passivation remnant by patterning the passivation layer;
depositing at least a first portion of a channel layer and a barrier layer of the HEMT by performing a second epitaxial growth process in the presence of the passivation remnant;
removing the passivation remnant; and
forming a gate electrode of the HEMT in the recess.

According to an embodiment:
said passivation layer is deposited on the back barrier layer;
said passivation remnant is formed on the back barrier layer;
said channel layer is deposited on the back barrier layer; and
said removing of the passive remnant forms a recess in the channel layer.

According to an embodiment, the method further comprises:
depositing, with the first epitaxial growth process, a first portion of a channel layer of the HEMT on the back barrier layer, and
wherein:
   said passivation layer is deposited on the first portion of the channel layer;
   said passivation remnant is formed on the first portion of the channel layer; and
   a second portion of the channel layer is deposited on the first portion of the channel layer.

According to an embodiment, the method further comprises depositing a dielectric cap layer on the barrier layer before removing the passivation remnant.

According to an embodiment, forming the gate electrode includes:
depositing a gate dielectric layer on sidewalls of the channel layer and the barrier in the recess, and on a top surface of the dielectric cap layer;
patterning the gate dielectric layer; and
filling the recess by depositing a gate metal on the liner layer or gate dielectric layer in the recess.

According to an embodiment, the first epitaxial growth process forms an aluminum nitride layer on a semiconductor substrate, a super lattice on the aluminum nitride layer, a first layer of gallium nitride doped with carbon on the super lattice, and the back barrier layer on the first layer of gallium nitride.

According to an embodiment, the back barrier layer is a second layer of gallium nitride.

According to an embodiment, the back barrier layer is doped with magnesium.

According to an embodiment, the channel layer is a third layer of gallium nitride.

According to an embodiment, the barrier layer is aluminum gallium nitride.

According to an embodiment, the method further comprises forming a source electrode of the HEMT and a drain electrode of the HEMT in contact with the channel layer.

According to an embodiment, the drain electrode is farther from the gate electrode than is the source electrode.

According to an embodiment, removing the passivation remnant includes performing a wet etch.

According to an embodiment, the first portion of the channel layer and the second portion of the channel layer are gallium nitride.

According to an embodiment, the first portion of the channel layer and the second portion of the channel layer include intrinsic gallium nitride.

### BRIEF DESCRIPTION OF THE SEVERAL VIEWS OF THE DRAWINGS

Figures 1A-1G are cross-sectional views of a single transistor at various stages of forming an HEMT, in accordance with one embodiment.
Figures 2A-2F are cross-sectional views of a single transistor at various stages of forming an HEMT, in accordance with one embodiment.
Figures 3A-3F are cross-sectional views of a single transistor at various stages of forming an HEMT, in accordance with one embodiment.
Figure 4 is a flow diagram of a method for forming an HEMT, in accordance with one embodiment.
Figure 5 is a flow diagram of a method for forming an HEMT, in accordance with one embodiment.
Figure 6 is a flow diagram of a method for forming an HEMT, in accordance with one embodiment.

### DETAILED DESCRIPTION

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known systems, components, and circuitry associated with integrated circuits have not been shown or described in detail, to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to." Further, the terms "first," "second," and similar indicators of sequence are to be construed as interchangeable unless the context clearly dictates otherwise.

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

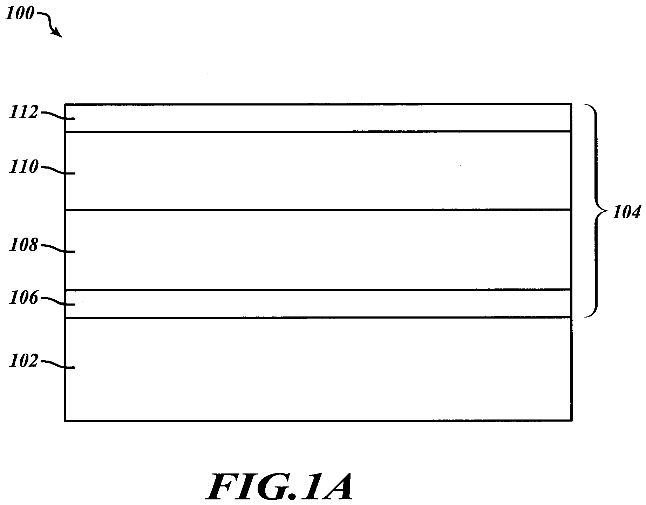

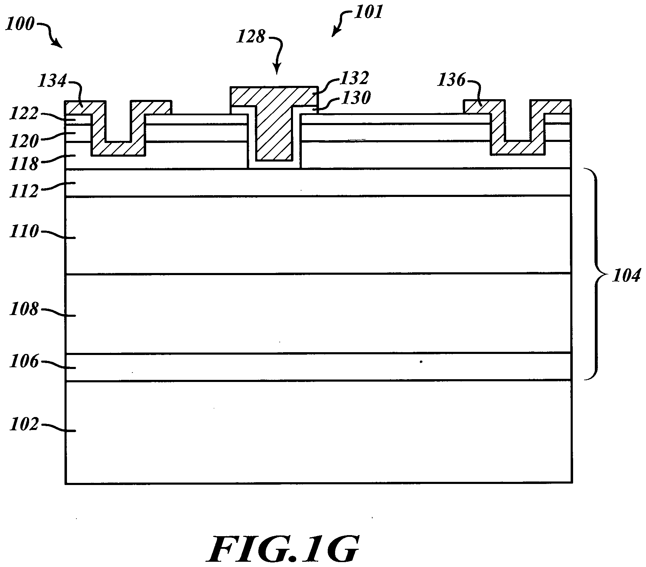

Figures 1A-1G are cross-sectional views of a single transistor 100 at various stages of forming an HEMT 101 (see Figure 1G), in accordance with one embodiment.

In Figure 1A, the single transistor 100 includes a substrate 102, in accordance with one embodiment. The substrate 102 can include a semiconductor material. In one embodiment, the substrate 102 includes silicon. However, the substrate 102 can include other types of semiconductor materials or crystals such as sapphire, silicon carbide, aluminum nitride. In some embodiments, the substrate 102 may include one or more layers of dielectric material. The substrate 102 can include other materials suitable for forming an HEMT.

In Figure 1 A, a first epitaxial growth process has been performed to form a stack of layers 104, in accordance with one embodiment. During the first epitaxial growth process, the stack of layers is grown epitaxially from the substrate 102. The various separate layers can be formed by adjusting the parameters of the epitaxial growth process in situ. For example, the epitaxial growth process can include flowing one or more gases or other materials into a deposition chamber in which the single transistor 100 (at this stage part of a semiconductor wafer) is positioned. The temperature, pressure, and materials can be adjusted throughout the epitaxial growth process to form the various layers of the stack 104. In some cases, when one layer of the stack 104 is complete, a purging process may be performed to purge any excess gases or byproducts from the deposition chamber before beginning growth of the next layer.

In one embodiment, the first epitaxial growth process forms a layer 106 on the substrate 102. In one embodiment, the layer 106 includes aluminum nitride. The aluminum nitride layer 106 may be formed as a precursor to forming a plurality of gallium nitride layers. Aluminum nitride may be selected as the first layer because gallium can be damaging to the substrate 102, in particular when the substrate 102 includes silicon. Accordingly, the epitaxial growth process first forms the layer 106 of aluminum nitride so that layers of gallium nitride may subsequently be formed. Alternatively, other materials can be utilized for the layer 106 and subsequent layers without departing from the scope of the present disclosure.

After formation of the layer 106, a super lattice 108 is formed on the layer 106 during the first epitaxial growth process. The super lattice 108 is illustrated as a single layer in Figure 1A. However, in practice, the super lattice 108 may include a large number of layers. In an example in which the layer 106 is aluminum nitride and subsequent layers of gallium nitride are to be formed, the first layer of the super lattice 108 can include a layer of aluminum gallium nitride in which the percentage of aluminum is high and the percentage of gallium is low to enable epitaxial growth from the layer of aluminum nitride. Subsequent layers of the super lattice 108 include aluminum gallium nitride with increasing concentrations of gallium and decreasing concentrations of aluminum. Finally, a top layer of the super lattice 108 may include gallium nitride without any aluminum. The super lattice 108 may include up to 200 layers. The super lattice 108 can include other materials and structures without departing from the scope of the present disclosure.

After formation of the super lattice 108, a layer 110 is formed atop the super lattice 108. In an example in which the super lattice 108 is a transitional structure including.a plurality of layers that gradually transition from aluminum nitride to gallium nitride, the layer 110 can include gallium nitride. In one embodiment, the layer of gallium nitride 110 includes P type dopants. In one embodiment, the layer gallium nitride 110 is doped with carbon atoms. The total thickness of the layer 110 may be about 2 µm. The total thickness of the super lattice 108 may also be about 2 µm. The composition of the layers 110 and 108 may facilitate formation of an HEMT device that can be operated with very high voltages. For example, the composition of the layers 110 and 108 may facilitate operation of an HEMT device with more than 600 V between terminals of the HEMT device. Other materials, thicknesses, and operating voltages can be utilized without departing from the scope of the present disclosure.

After formation of the layer 110, a back barrier layer 112 is formed on the layer 110 with the first epitaxial growth process. In an example in which the layer 110 includes carbon doped gallium nitride, the back barrier layer 112 may include gallium nitride. The gallium nitride back barrier layer 112 may be doped with P type atoms. In one example, the back barrier layer 112 may be doped with magnesium atoms. The back barrier layer 112 may be between 50 nm and 300 nm in thickness. Other materials and thicknesses can be utilized for the back barrier layer 112 without departing from the scope of the present disclosure. Furthermore, as will be set forth for the below, in some embodiments, the back barrier layer 112 may not be present.

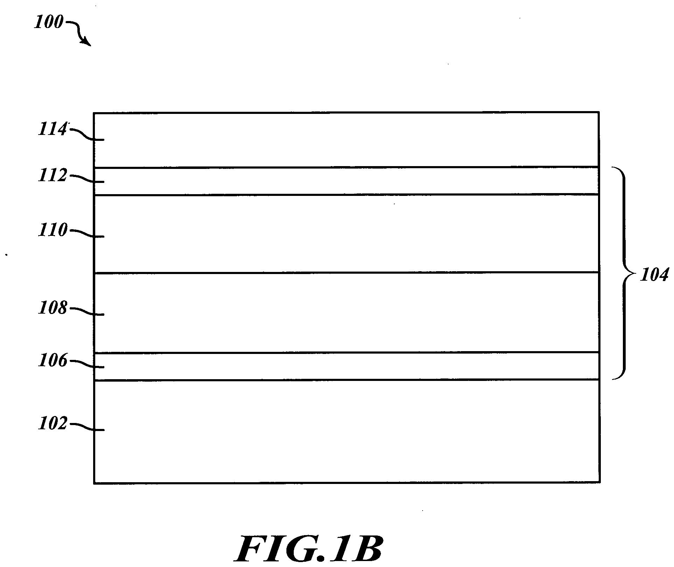

In Figure 1B, the first epitaxial growth process has been stopped. After the first epitaxial growth process has been stopped, a passivation layer 114 has been formed on the stack of layers 104. In the example Figure 1B, the passivation layer 114 is formed directly on the top surface of the back barrier layer 112. The passivation layer 114 can include a dielectric material with a thickness between 200 nm and 400 nm, though other thicknesses can be utilized without departing from the scope of the present disclosure.

In one embodiment, the passivation layer 114 includes silicon oxide. The silicon oxide may be formed with an atomic layer deposition (ALD) process. The passivation layer may also include a layer of tetraethyl orthosilicate (TEOS) on the silicon oxide. The TEOS may be formed by CVD, ALD, or other suitable deposition processes. Other processes and materials can be utilized without departing from the scope of the present disclosure.

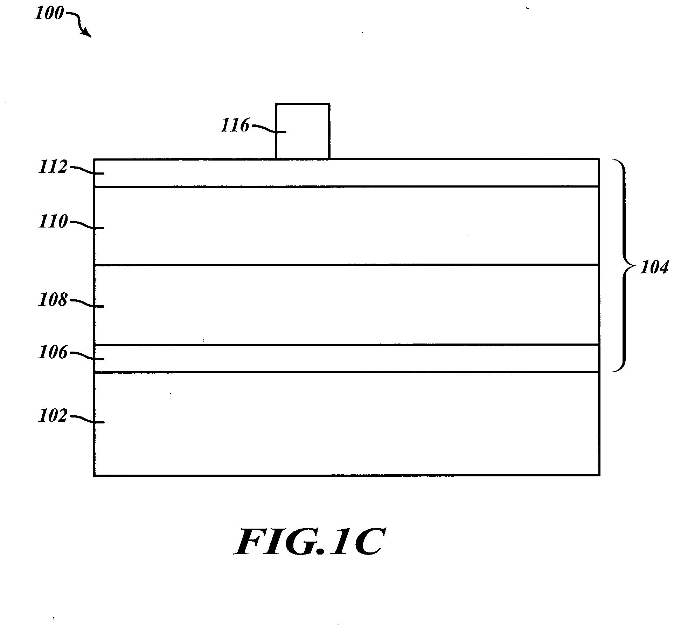

In Figure 1C, the passivation layer 114 has been patterned to form a dielectric structure 116 on the back barrier layer 112. The dielectric structure 116 corresponds to a passivation remnant, or remnant of the passivation layer 114. In particular, the passivation layer 114 can be patterned using a photolithography process to remove the passivation layer 114 except for the portion corresponding to the dielectric structure 116. In one embodiment, the patterning process can include forming a mask on the passivation layer 114 and then performing a wet or dry etch in the presence of the mask to remove the portions of the passivation layer 114 that are not covered by the mask. This leaves the dielectric structure 116. After the wet or dry etching process, a wet treatment can then be performed to repair any damage to the back barrier layer 112 that may have occurred during the wet or dry etching process. Other processes for forming the dielectric structure 116 can be utilized without departing from the scope of the present disclosure. As will be set forth in more detail below, the dielectric structure 116 is positioned at a location at which a recess the gate electrode will be formed for the HEMT device.

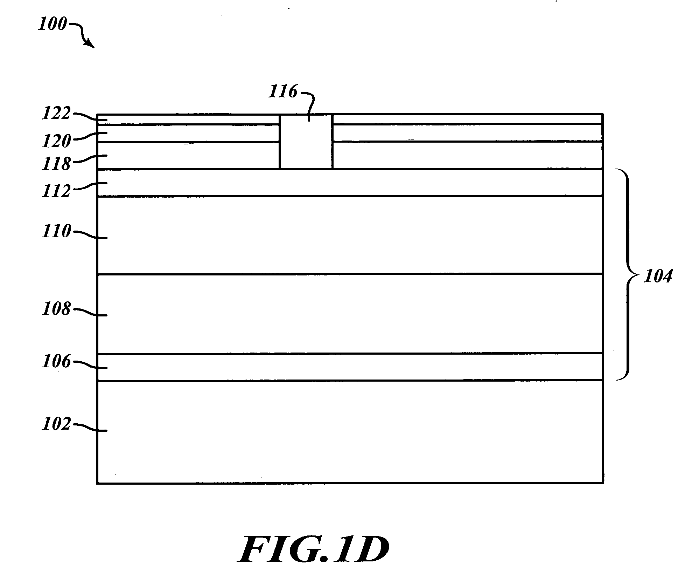

In Figure 1D, a second epitaxial growth process has been performed in the presence of the dielectric structure 116, according to one embodiment. The second epitaxial growth process forms the channel layer 118 and the barrier layer 120.

In one embodiment, the channel layer 118 is gallium nitride and has a thickness between 50 nm and 150 nm. In one embodiment, the channel layer 118 is intrinsic gallium nitride and does not include any doping. The channel layer 118 corresponds to the layer in which an electron gas is formed during operation of the transistor. Free electrons flow through the channel region based on biasing between source and drain electrodes and the control voltage applied to the gate electrode, as will be set forth in more detail below. The channel layer can have other materials and thicknesses without departing from the scope of the present disclosure.

In one embodiment, the barrier layer 120 includes aluminum gallium nitride. The percentage of aluminum may be between 15% and 30%, though other compositions can be utilized without departing from the scope of the present disclosure. The barrier layer 120 can have a thickness between 30 nm and 70 nm. Other compositions and thicknesses can be utilized for the barrier layer 120 without departing from the scope of the present disclosure.

Because the dielectric structure 116 does not share the crystal structure of the back barrier layer 112, the epitaxial growth process does not cause growth of the gallium nitride or aluminum gallium nitride from the dielectric structure 116. Accordingly, the layers 118 and 120 do not grow on the top of the dielectric structure 116. The layers 118 and 120 above the sidewalls of the dielectric structure 116.

In Figure 1D, a dielectric cap layer 122 has also been formed on the layer 120. The dielectric layer 122 can include silicon nitride and can have a thickness between 20 nm and 50 nm. Other materials and thicknesses can be utilized without departing from the scope of the present disclosure.

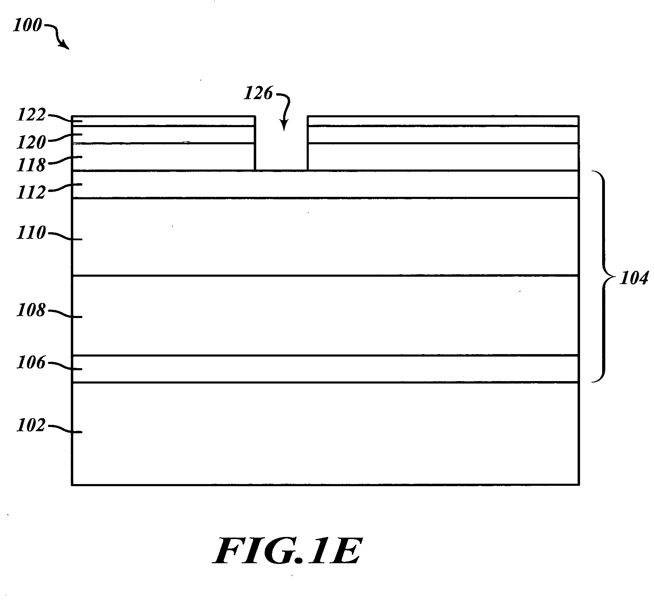

In Figure 1E, an etching process has been performed to remove the dielectric structure 116, effectively leaving a recess 126 and the channel layer 118, the barrier layer 120, and the dielectric cap layer 122. As will be set forth in more detail below, the recess 126 corresponds to the location in which the gate electrode of the HEMT will be formed. The etching process selectively etches the material of the dielectric structure 116 with respect to the materials of the channel layer 118, the barrier layer 120, and the dielectric cap layer 122. Because the etching process does not etch the material of the layers 112, 118, and 120, there is little or no damage to the layers 112, 118, and 120.

The process for forming the gate recess 126 shown in relation to Figures 1A-1E contrasts with other possible solutions for forming a gate recess in the channel layer 118 and the barrier layer 120. For example, in another possible solution the dielectric structure is not formed and the gate recess is formed by masking and etching the barrier layer 120 and the channel layer 118. However, the problem with this possible solution is that the etching process also partially etches the back barrier layer 112 or otherwise damages the back barrier layer 112 and sidewalls of layers 120 and 118. Advantageously, the process described in relation to Figures 1A-1E forms the gate recess 126 by growing the channel layer 118 and the barrier layer 120 in the presence of the dielectric structure 116. The wet etch that removes the dielectric structure 116 causes little or no damage to the back barrier layer 112 because the etch chemistry for removing the materials of the dielectric structure 116 does not match the materials of the layers 112, 118, and 120.

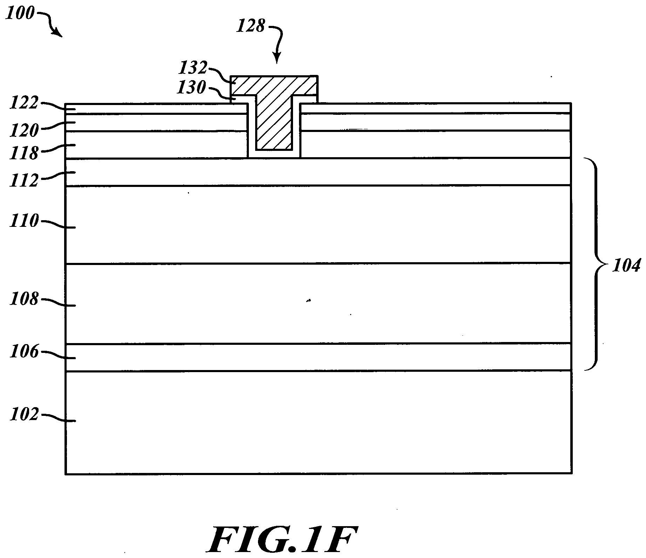

In Figure 1F, a gate electrode 128 has been formed in the gate recess 126, in accordance with one embodiment. The gate electrode 128 can include a gate dielectric 130 and a gate metal 132. The gate dielectric 130 is in contact with the back barrier layer 112, the sidewalls of the layers 118 120, and 122, and on the top surface of the layer 122. The gate dielectric 130 can include aluminum oxide (alumina) or other suitable materials such as AlN, SiN, SiO2. The gate dielectric 130 can be deposited by ALD, CVD, PVD, or other suitable deposition processes. The gate dielectric 130 can have a thickness between 10 nm and 50 nm. Other thicknesses and materials can be utilized for the gate dielectric 130 without departing from the scope of the present disclosure.

The gate metal 132 fills the remainder of the gate recess 126. In particular, the gate metal 132 is in contact with the gate metal 132 in the gate recess 126 and on top of the dielectric cap layer 122. The gate metal 132 can include tungsten and can be deposited by PVD, ALD, CVD, or other suitable deposition processes. The gate metal 132 can include other materials and configurations without departing from the scope of the present disclosure. For example, while the gate metal 132 is shown as a single gate metal, in practice, multiple gate metals may be present.

Initially, the gate dielectric 130 and the gate metal 132 may be deposited on the entire top surface of the dielectric cap layer 122. Afterwards, a photolithography and etching process can be performed to pattern the gate electrode 128 as shown in Figure 1F. The gate electrode 128 can have other configurations without departing from the scope of the present disclosure.

In Figure 1G, a source electrode 134 and a drain electrode 136 have been formed, in accordance with one embodiment. The source electrode 134 and the drain electrode 136 can be formed after formation of the gate electrode 128. In particular, a photolithography process can be performed to form trenches that extend partially into the channel layer 118. A source/drain metal can then be deposited and patterned to form the source electrode 134 and the drain electrode 136. The source/drain metal can include TiAl, TaAl, Au, or other suitable conductive materials. The source/drain metal can be deposited by PVD, ALD, CVD, or other suitable deposition processes. As can be seen, the source electrode 134 is closer to the gate electrode 128 than is the drain electrode 136. This can be beneficial in the electrical function of the HEMT 101.

The HEMT 101 can include various other layers including passivation layers and other dielectric layers to isolate and protect the source/drain metals in the gate electrode 128. The HEMT can be operated by applying a control voltage to the gate electrode 128 and biasing the source electrode 134 and the drain electrode 136. Depending on the control and bias voltages, the HEMT may be turned on or turned off. When the HEMT is turned on, the current of the electron gas may flow through the channel layer 118 and under the bottom of the gate electrode 128 between the drain electrode 136 and the source electrode 134.

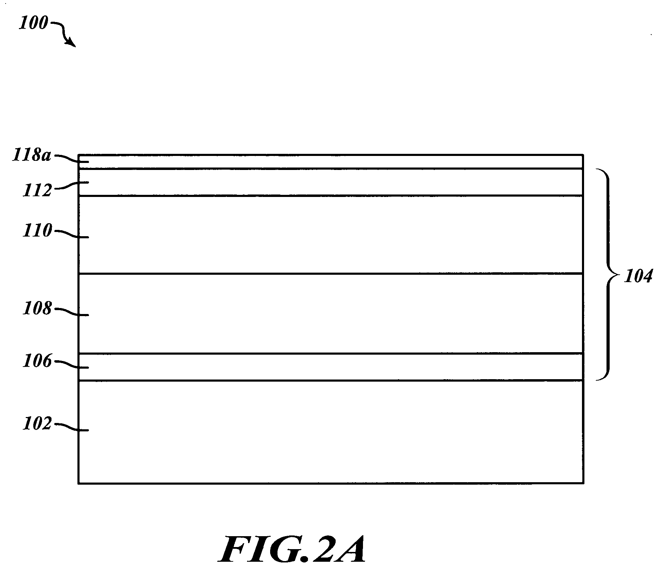

Figures 2A-2F are cross-sectional views of an integrated circuit 100 at various stages of forming an HEMT 101, in accordance with one embodiment. The process for forming the HEMT 101 of Figures 2A-2F is substantially similar in many regards to the process shown in relation to Figures 1A-1G. Unless otherwise stated, the materials and processes shown in relation to Figures 2A-2F may be substantially similar to those described in relation to Figures 1A-1G.

In Figure 2A, the first epitaxial growth process has been performed, in accordance with one embodiment. The first epitaxial growth process forms the stack of layers 104 as described previously. However, the epitaxial growth process 104 of Figure 2A also forms a first portion of the channel layer 118a. This can be beneficial for embodiments in which the gate recess does not extend through the entirety of the channel layer 118, as will be set forth in more detail below.

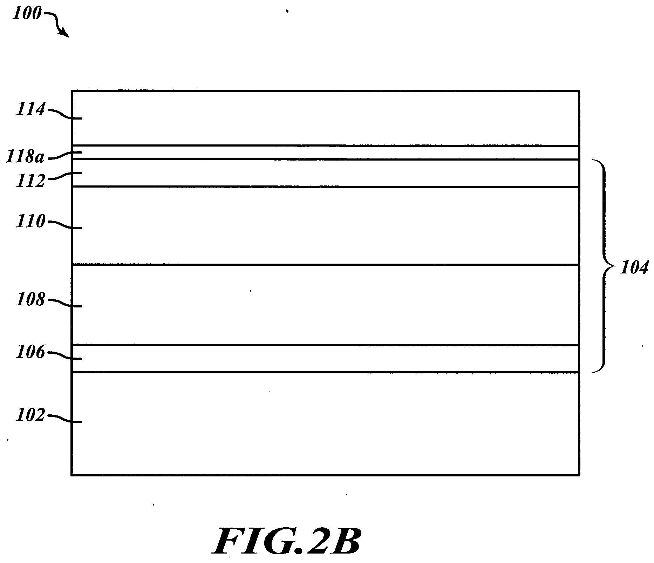

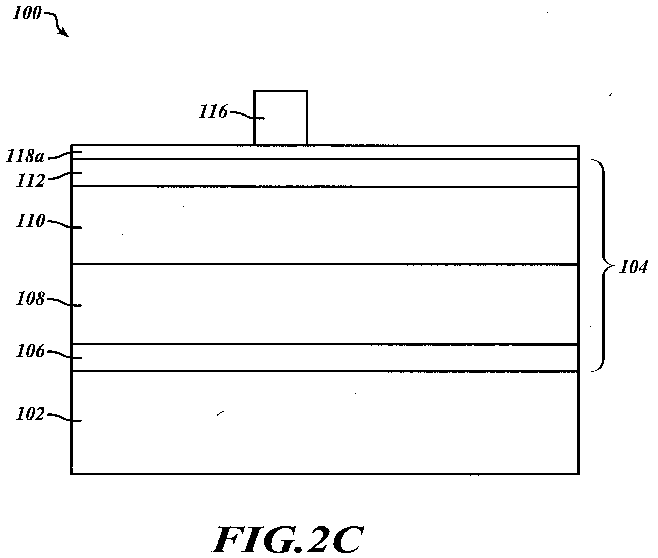

In Figure 2B, the passivation layer 114 is formed on the first portion of the channel layer 118a, in accordance with one embodiment. In Figure 2C, the passivation layer 114 has been patterned to form the dielectric structure 116 on the top surface of the first portion of the channel layer 118a, in accordance with one embodiment.

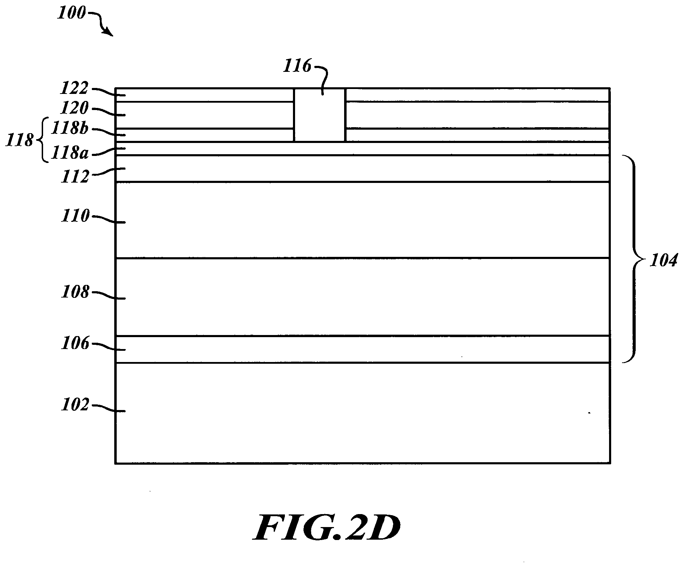

In Figure 2D, the second epitaxial growth process is performed in the presence of the dielectric structure 116, in accordance with one embodiment. The second epitaxial growth process forms a second portion of the channel layer 118b and the barrier layer 120. The dielectric cap layer 122 is also formed. The first portion of the dielectric layer 118a and the second portion of the dielectric layer 118b are the same material. While the first portion of the dielectric layer 118a and the second portion of the dielectric layer 118b are shown as distinct layers in Figure 2D, in practice, they form a single channel layer 118 after the second epitaxial growth process.

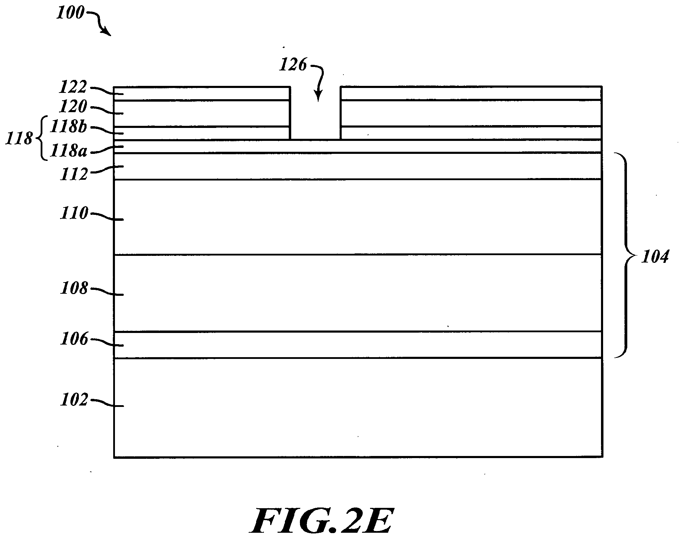

In Figure 2E, an etching process has been performed to form the gate recess 126, in accordance with one embodiment. The etching process removes the dielectric structure 126. The bottom of the gate recess 126 corresponds to the top of the first portion of the channel layer 118a. The sidewalls of the second portion of the channel layer 118b, the barrier layer 120, and the dielectric cap layer 122 are exposed in the gate recess 126.

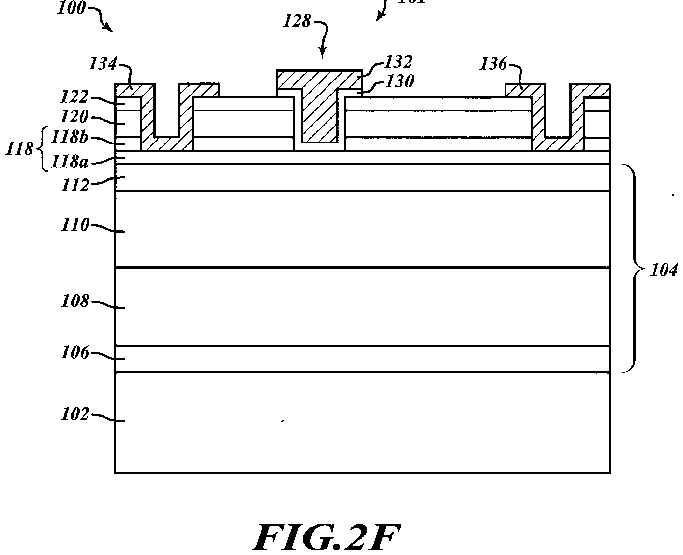

In Figure 2F, the gate electrode 128, the source electrode 134, and the drain electrode 136 have been formed, in accordance with one embodiment. The gate dielectric 130 is in contact with the sidewalls of the second portion of the channel layer 118b, the barrier layer 120, and the dielectric cap layer 122. Processing of the HEMT 101 is substantially complete.

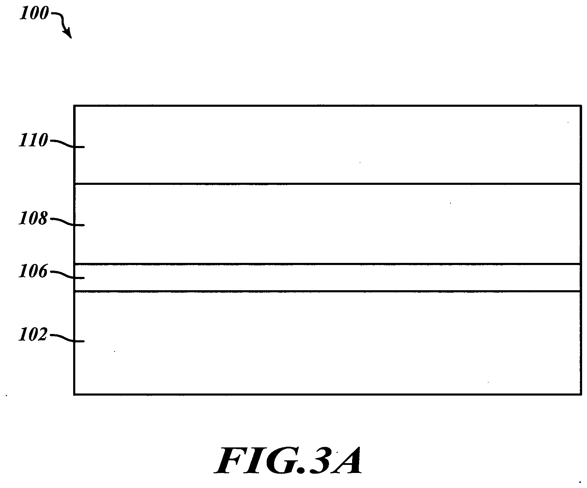

Figures 3A-2F are cross-sectional views of an integrated circuit 100 at various stages of forming an HEMT 101, in accordance with one embodiment. The process for forming the HEMT 101 of Figures 3A-3F is substantially similar in many regards to the process shown in relation to Figures 1A-1G. Unless otherwise stated, the materials and processes shown in relation to Figures 3A-3F may be substantially similar to those described in relation to Figures 1A-1G.

In Figure 3A, the first epitaxial growth process has been performed, in accordance with one embodiment. The first epitaxial growth process forms the stack of layers 104 as described previously. However, the epitaxial growth process 104 of Figure 3A does not form the back barrier layer 112. Accordingly, the HEMT 101 does not include a back barrier layer in the embodiment of Figures 3A-3F.

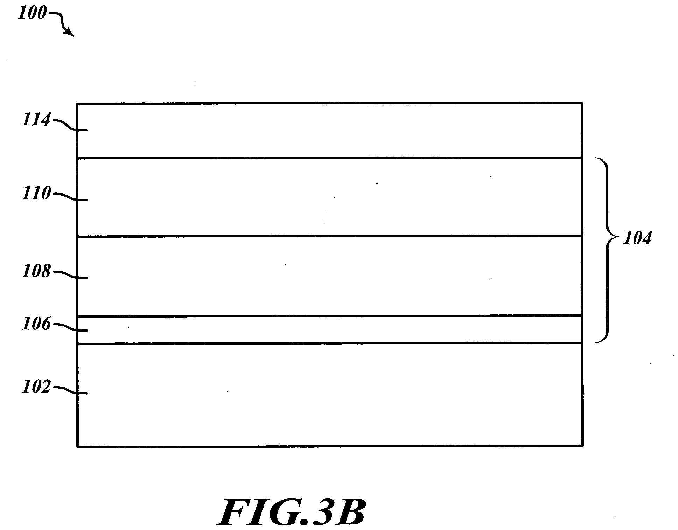

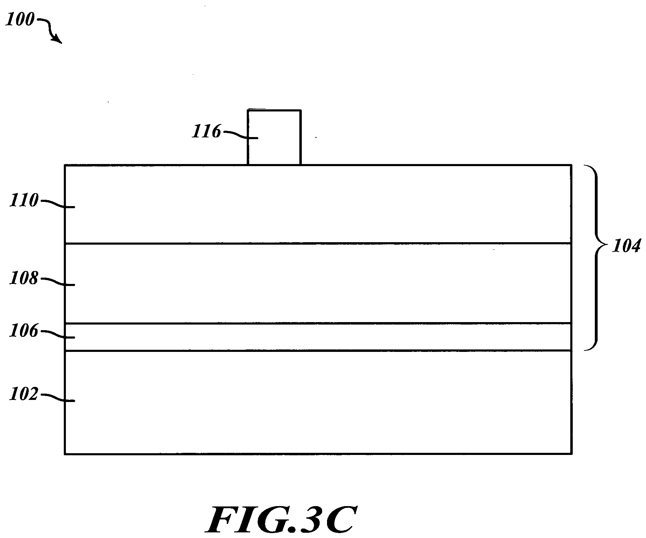

In Figure 3B, the passivation layer 114 is formed on the layer 110, in accordance with one embodiment. In Figure 3C, the passivation layer 114 has been patterned to form the dielectric structure 116 on the top surface of the layer 110, in accordance with one embodiment.

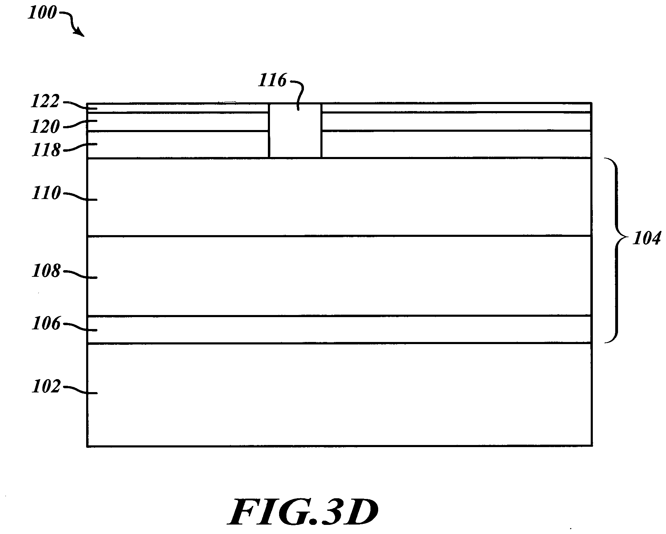

In Figure 3D, the second epitaxial growth process is performed in the presence of the dielectric structure 116, in accordance with one embodiment. The second epitaxial growth process forms the channel layer 118 and the barrier layer 120. The dielectric cap layer 122 is also formed.

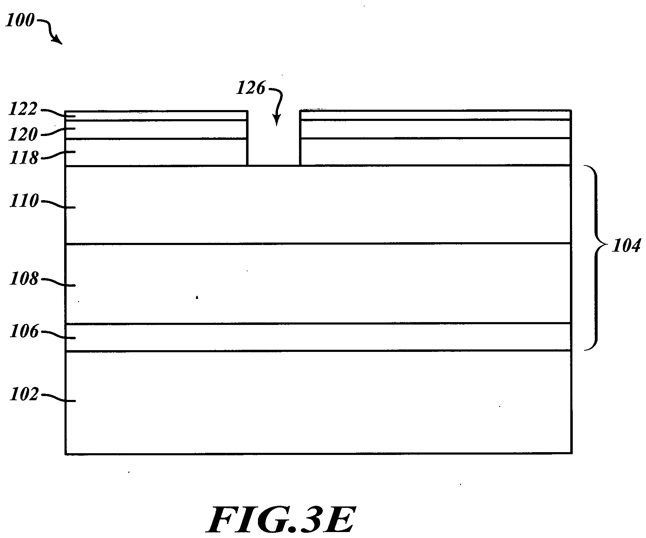

In Figure 3E, an etching process has been performed to form the gate recess 126, in accordance with one embodiment. The etching process removes the dielectric structure 126. The bottom of the gate recess 126 corresponds to the top of the layer 110. The sidewalls of the channel layer 118, the barrier layer 120, and the dielectric cap layer 122 are exposed in the gate recess 126.

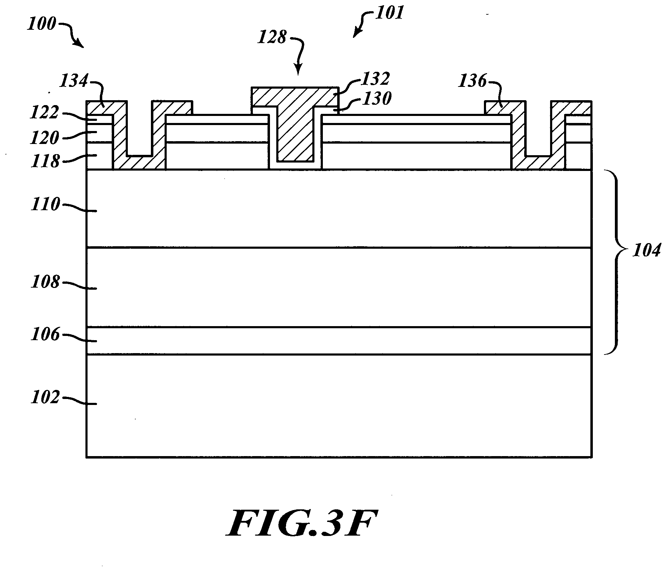

In Figure 3F, the gate electrode 128, the source electrode 134, and the drain electrode 136 have been formed, in accordance with one embodiment. The gate dielectric 130 is in contact with the top surface of the layer 110 and the sidewalls of the channel layer 118, the barrier layer 120, and the dielectric cap layer 122. Processing of the HEMT 101 is substantially complete.

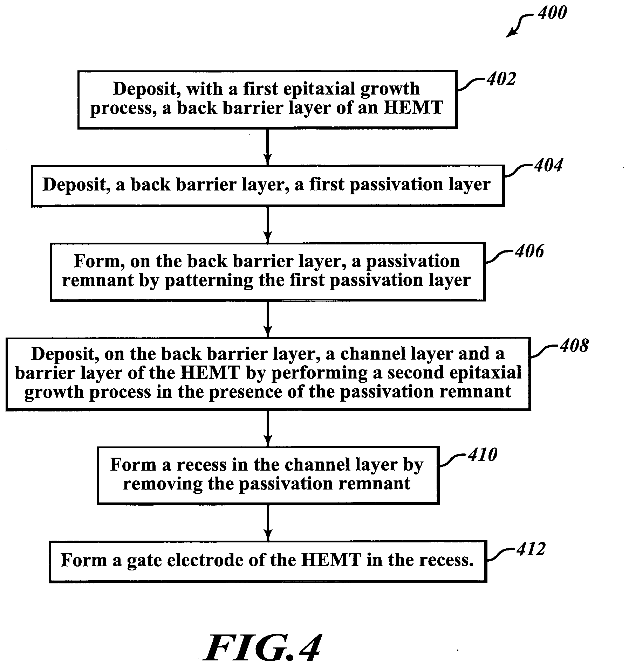

Figure 4 is a flow diagram of a method 400 for forming an HEMT device, in accordance with one embodiment. The method 400 can utilize components, structures, and processes described in relation to Figures 1A-3F. At 402, the method 400 includes depositing, with a first epitaxial growth process, a back barrier layer of an HEMT. At 404, the method 400 includes depositing, on the back barrier layer, a passivation layer. At 406, the method 400 includes forming, on the back barrier layer, a passivation remnant by patterning the passivation layer. At 408, the method 400 includes depositing, on the back barrier layer, a channel layer and a barrier layer of the HEMT by performing a second epitaxial growth process in the presence of the passivation remnant. At 410, the method 400 includes forming a recess in the channel layer by removing the passivation remnant. At 412, the method 400 includes forming a gate electrode of the HEMT in the recess.

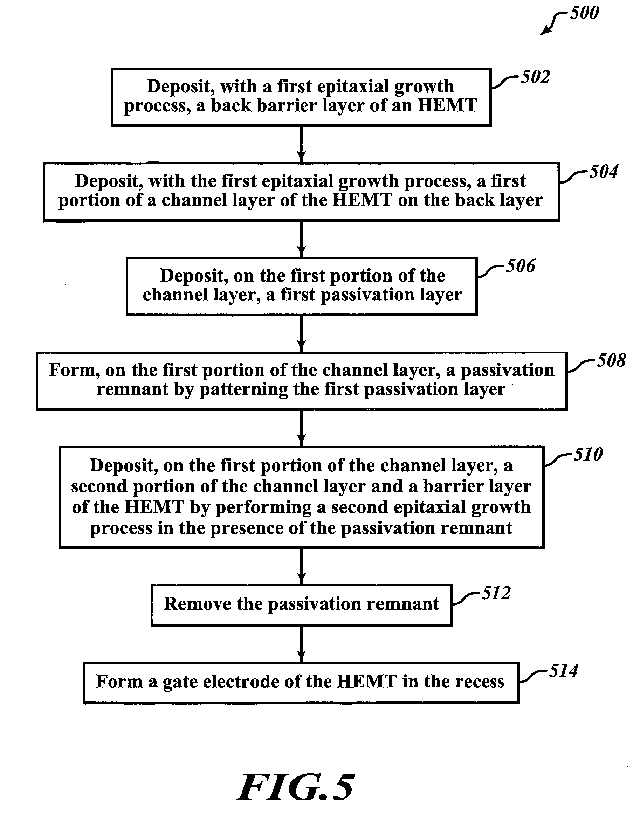

Figure 5 is a flow diagram of a method 500 for forming an HEMT device, in accordance with one embodiment. The method 500 can utilize components, structures, and processes described in relation to Figures 1A-3F. At 502, the method 500 depositing, with a first epitaxial growth process, a back barrier layer of an HEMT. At 504, the method 500 includes depositing, with the first epitaxial growth process, a first portion of a channel layer of the HEMT on the back barrier layer. At 506, the method 500 includes depositing, on the first portion of the channel layer, a passivation layer. At 508, the method 500 includes forming, on the first portion of the channel layer, a passivation remnant by patterning the passivation layer. At 510, the method 500 includes depositing, on the first portion of the channel layer, a second portion of the channel layer and a barrier layer of the HEMT by performing a second epitaxial growth process in the presence of the passivation remnant. At 512, the method 500 includes removing the passivation remnant. At 514, the method 500 includes forming a gate electrode of the HEMT in the recess.

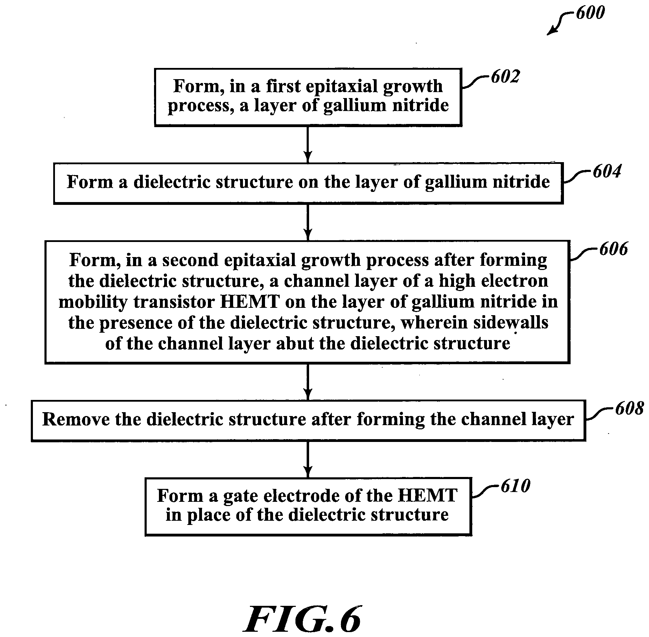

Figure 6 is a flow diagram of a method 600 for forming an HEMT device, in accordance with one embodiment. The method 600 can utilize components, structures, and processes described in relation to Figures 1A-3F. At 602, the method 600 includes forming, in a first epitaxial growth process, a layer of gallium nitride. At 604, the method 600 includes forming a dielectric structure on the layer of gallium nitride. At 606, the method 600 includes forming, in a second epitaxial growth process after forming the dielectric structure, a channel layer of an HEMT on the layer of gallium nitride in the presence of the dielectric structure, wherein sidewalls of the channel layer abut the dielectric structure. At 608, the method 600 includes removing the dielectric structure after forming the channel layer. At 610, the method 600 includes forming a gate electrode of the HEMT in place of the dielectric structure.

In one embodiment, a method includes depositing, with a first epitaxial growth process, a back barrier layer of an HEMT and depositing, on the back barrier layer, a passivation layer. The method includes forming, on the back barrier layer, a passivation remnant by patterning the passivation layer and depositing, on the back barrier layer, a channel layer and a barrier layer of the HEMT by performing a second epitaxial growth process in the presence of the passivation remnant. The method includes forming a recess in the channel layer by removing the passivation remnant and forming a gate electrode of the HEMT in the recess.

In one embodiment, the method includes comprising depositing a dielectric cap layer on the barrier layer before removing the passivation remnant. In one embodiment, forming the gate electrode includes depositing a gate dielectric layer on sidewalls of the channel layer and the barrier in the recess, and on a top surface of the dielectric cap layer, patterning the gate dielectric layer, and filling the recess by depositing a gate metal on the liner layer in the recess.

In one embodiment, the first epitaxial growth process forms an aluminum nitride layer on a semiconductor substrate, a super lattice on the aluminum nitride layer, a first layer gallium nitride doped with carbon on the super lattice, and the back barrier layer on the first layer of gallium nitride. In one embodiment, the back barrier layer is a second layer of gallium nitride. In one embodiment, the back barrier layer is doped with magnesium. In one embodiment, the channel is a third layer of gallium nitride. In one embodiment, the barrier layer is aluminum gallium nitride. In one embodiment, the method includes forming a source electrode of the HEMT and a drain electrode of the HEMT in contact with the channel layer. The drain electrode is farther from the gate electrode than is the source electrode.

In one embodiment, a method includes depositing, with a first epitaxial growth process, a back barrier layer of a high electron mobility transistor (HEMT) and depositing, with the first epitaxial growth process, a first portion of a channel layer of the HEMT on the back barrier layer. The method includes depositing, on the first portion of the channel layer, a passivation layer and forming, on the first portion of the channel layer, a passivation remnant by patterning the passivation layer. The method includes depositing, on the first portion of the channel layer, a second portion of the channel layer and a barrier layer of the HEMT by performing a second epitaxial growth process in the presence of the passivation remnant, removing the passivation remnant, and forming a gate electrode of the HEMT in the recess.

In one embodiment, the method includes depositing a dielectric cap layer on the barrier layer before removing the passivation remnant. In one embodiment, forming the gate electrode includes depositing a gate dielectric layer on sidewalls of the channel layer and the barrier in the recess, and on a top surface of the dielectric cap layer, patterning the gate dielectric layer, and filling the recess by depositing a gate metal on the liner layer in the recess.

In one embodiment, removing the passivation remnant includes performing a wet etch.

In one embodiment, the first portion of the channel layer and the second portion of the channel layer are gallium nitride. The first portion of the channel layer and the second portion of the channel layer may include intrinsic gallium nitride.

In one embodiment, the method includes forming a source electrode of the HEMT and a drain electrode of the HEMT in contact with the channel layer.

In one embodiment, a method includes forming, in a first epitaxial growth process, a layer of gallium nitride and forming a dielectric structure on the layer of gallium nitride. The method includes forming, in a second epitaxial growth process after forming the dielectric structure, a channel layer of a HEMT on the layer of gallium nitride in the presence of the dielectric structure, wherein sidewalls of the channel layer abut the dielectric structure. The method includes removing the dielectric structure after forming the channel layer and forming a gate electrode of the HEMT in place of the dielectric structure.

In one embodiment, forming the dielectric structure includes depositing a dielectric layer on the layer of gallium nitride and patterning the dielectric layer. In one embodiment, the channel layer includes gallium nitride.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

Example embodiments of the present disclosure are summarized here. Other embodiments can also be understood from the entirety of the specification and the claims.

Example 1. A method, comprising:
depositing, with a first epitaxial growth process, a back barrier layer of a high electron mobility transistor (HEMT);
depositing, on the back barrier layer, a passivation layer;
forming, on the back barrier layer, a passivation remnant by patterning the passivation layer;
depositing, on the back barrier layer, a channel layer and a barrier layer of the HEMT by performing a second epitaxial growth process in the presence of the passivation remnant;
forming a recess in the channel layer by removing the passivation remnant; and
forming a gate electrode of the HEMT in the recess.

Example 2. The method of example 1, comprising depositing a dielectric cap layer on the barrier layer before removing the passivation remnant.

Example 3. The method of example 2, wherein forming the gate electrode includes:
depositing a gate dielectric layer on sidewalls of the channel layer and the barrier in the recess, and on a top surface of the dielectric cap layer;
patterning the gate dielectric layer; and
filling the recess by depositing a gate metal on the liner layer in the recess.

Example 4. The method of any of examples 1 to 3, wherein the first epitaxial growth process forms an aluminum nitride layer on a semiconductor substrate, a super lattice on the aluminum nitride layer, a first layer of gallium nitride doped with carbon on the super lattice, and the back barrier layer on the first layer of gallium nitride.

Example 5. The method of any of examples 1 to 4, wherein the back barrier layer is a second layer of gallium nitride.

Example 6. The method of example 5, wherein the back barrier layer is doped with magnesium.

Example 7. The method of example 6, wherein the channel layer is a third layer of gallium nitride.

Example 8. The method of example 7, wherein the barrier layer is aluminum gallium nitride.

Example 9. The method of any of examples 1 to 8, comprising forming a source electrode of the HEMT and a drain electrode of the HEMT in contact with the channel layer.

Example 10. The method of example 9, wherein the drain electrode is farther from the gate electrode than is the source electrode.

Example 11. A method, comprising:
depositing, with a first epitaxial growth process, a back barrier layer of a high electron mobility transistor (HEMT);
depositing, with the first epitaxial growth process, a first portion of a channel layer of the HEMT on the back barrier layer;
depositing, on the first portion of the channel layer, a passivation layer;
forming, on the first portion of the channel layer, a passivation remnant by patterning the passivation layer;
depositing, on the first portion of the channel layer, a second portion of the channel layer and a barrier layer of the HEMT by performing a second epitaxial growth process in the presence of the passivation remnant;
removing the passivation remnant; and
forming a gate electrode of the HEMT in the recess.

Example 12. The method of example 11, comprising depositing a dielectric cap layer on the barrier layer before removing the passivation remnant.

Example 13. The method of example 12, wherein forming the gate electrode includes:
depositing a gate dielectric layer on sidewalls of the channel layer and the barrier in the recess, and on a top surface of the dielectric cap layer;
patterning the gate dielectric layer; and
filling the recess by depositing a gate metal on the gate dielectric layer in the recess.

Example 14. The method of any of examples 11 to 13, wherein removing the passivation remnant includes performing a wet etch.

Example 15. The method of any of examples 11 to 14, wherein the first portion of the channel layer and the second portion of the channel layer are gallium nitride.

Example 16. The method of example 15, wherein the first portion of the channel layer and the second portion of the channel layer include intrinsic gallium nitride.

Example 17. The method of any of example 11 to 16, comprising forming a source electrode of the HEMT and a drain electrode of the HEMT in contact with the channel layer.

Example 18. A method, comprising:
forming, in a first epitaxial growth process, a layer of gallium nitride;
forming a dielectric structure on the layer of gallium nitride;
forming, in a second epitaxial growth process after forming the dielectric structure, a channel layer of a high electron mobility transistor (HEMT) on the layer of gallium nitride in the presence of the dielectric structure, wherein sidewalls of the channel layer abut the dielectric structure;
removing the dielectric structure after forming the channel layer; and
forming a gate electrode of the HEMT in place of the dielectric structure.

Example 19. The method of example 18, wherein forming the dielectric structure includes depositing a dielectric layer on the layer of gallium nitride and patterning the dielectric layer.

Example 20. The method of example 19, wherein the channel layer includes gallium nitride.

## Claims

1. A method, comprising:
depositing, with a first epitaxial growth process, a back barrier layer of a high electron mobility transistor (HEMT);
depositing a passivation layer;
forming a passivation remnant by patterning the passivation layer;
depositing at least a first portion of a channel layer and a barrier layer of the HEMT by performing a second epitaxial growth process in the presence of the passivation remnant;
removing the passivation remnant; and
forming a gate electrode of the HEMT in the recess.

2. The method of claim 1, wherein:
said passivation layer is deposited on the back barrier layer;
said passivation remnant is formed on the back barrier layer;
said channel layer is deposited on the back barrier layer; and
said removing of the passive remnant forms a recess in the channel layer.

3. The method of claim 1, further comprising:
depositing, with the first epitaxial growth process, a first portion of a channel layer of the HEMT on the back barrier layer; and
wherein:
said passivation layer is deposited on the first portion of the channel-layer;
said passivation remnant is formed on the first portion of the channel layer and
a second portion of the channel layer is deposited on the first portion of the channel layer.

4. The method of any of claims 1 to 3, comprising depositing a dielectric cap layer on the barrier layer before removing the passivation remnant.

5. The method of claim 4, wherein forming the gate electrode includes:
depositing a gate dielectric layer on sidewalls of the channel layer and the barrier in the recess, and on a top surface of the dielectric cap layer;
patterning the gate dielectric layer; and
filling the recess by depositing a gate metal on the liner layer or gate dielectric layer in the recess.

6. The method of claim 2, or of claim 4 or 5 in their dependency on claim 2, wherein the first epitaxial growth process forms an aluminum nitride layer on a semiconductor substrate, a super lattice on the aluminum nitride layer, a first layer of gallium nitride doped with carbon on the super lattice, and the back barrier layer on the first layer of gallium nitride.

7. The method of claim of claim 6, wherein the back barrier layer is a second layer of gallium nitride.

8. The method of claim 7, wherein the back barrier layer is doped with magnesium.

9. The method of claim 8, wherein the channel layer is a third layer of gallium nitride.

10. The method of claim 9, wherein the barrier layer is aluminum gallium nitride.

11. The method of any of claims 1 to 10, comprising forming a source electrode of the HEMT and a drain electrode of the HEMT in contact with the channel layer.

12. The method of claim 11, wherein the drain electrode is farther from the gate electrode than is the source electrode.

13. The method of claim 3, or of any of claims 4, 5, 11, 12 in their dependency on claim 3, wherein removing the passivation remnant includes performing a wet etch.

14. The method of claim 3, or of any of claims 4, 5, 11 to 13 in their dependency on claim 3, wherein the first portion of the channel layer and the second portion of the channel layer are gallium nitride.

15. The method of claim 14, wherein the first portion of the channel layer and the second portion of the channel layer include intrinsic gallium nitride.

16. A method, comprising:
forming, in a first epitaxial growth process, a layer of gallium nitride;
forming a dielectric structure on the layer of gallium nitride;
forming, in a second epitaxial growth process after forming the dielectric structure, a channel layer of a high electron mobility transistor (HEMT) on the layer of gallium nitride in the presence of the dielectric structure, wherein sidewalls of the channel layer abut the dielectric structure;
removing the dielectric structure after forming the channel layer; and
forming a gate electrode of the HEMT in place of the dielectric structure.

17. The method of claim 16, wherein forming the dielectric structure includes depositing a dielectric layer on the layer of gallium nitride and patterning the dielectric layer.

18. The method of claim 17, wherein the channel layer includes gallium nitride.
